# EUROPEAN PATENT APPLICATION

(11) **EP 2 642 536 A2**
(43) Date of publication of application: **25.09.2013**
(21) Application number: 12188851.5
(22) Date of filing: 17.10.2012
(51) Int. Cl.: H01L 33/08, H01L 33/24, H01L 33/32, H01L 33/06

(54) **White light emitting diode**

(30) Priority: 20.03.2012 KR 20120028416
(71) Applicant: Samsung Electronics Co., Ltd, Gyeonggi-do 443-742 (KR)
(72) Inventor: Kim, Taek, 449-712 Gyeonggi-do (KR)
(74) Representative: Greene, Simon Kenneth

(57) **Abstract**

According to example embodiments, a white light-emitting diode may be configured to emit white light without a phosphor. According to example embodiments, a white light-emitting diode may include a first semiconductor layer (120) that includes a plurality of hexagonal-pyramid shape nanostructures (122) that protrude upwards from an upper surface of the first semiconductor layer, at least two multi-quantum well layers (140, 150) that are sequentially stacked on the hexagonal-pyramid shape nanostructures; and a second semiconductor layer (160) on the multi-quantum well layers. The at least two multi-quantum well layers may be configured to generate lights having different wavelengths, and white light may be generated by mixing the lights having different wavelengths.

## Description

### BACKGROUND

### Field

Example embodiments relate to white light-emitting diodes, and more particularly, to white light-emitting diodes that include a nano light-emitting unit having a hexagonal-pyramid type nanostructure and being configured to provide white light without a phosphor.

### Description of the Related Art

A light emitting diode (LED) may be a high efficiency and/or an eco-friendly light source, and thus, may be used in various devices such as displays, optical communication device, automobiles, or general lightings.

Phosphors may be used to emit white light in a white LED using an LED as a light source. For example, white light may be emitted by exciting a red phosphor, a green phosphor, and a blue phosphor by using a UV LED as a light source, or by using a blue LED as a light source and exciting a yellow phosphor, which is a complementary color to blue color. The color rendering index (CRI) of a white light emitting diode that uses a phosphor may be in the range from about 60 to about 80 levels. The structure to excite the phosphor using the blue LED or the UV LED may affect the CRI. Some phosphors may have a relatively short lifetime.

As a method of realizing white light by using only LEDs without using a phosphor, LEDs that respectively emits red, green, and blue visible light have been combined. For example, in the case of an LED that uses an InGaN layer as a light-emitting material, white light may be generated by using a property that a light-emitting color varies according to the variation of mole fraction of indium (In) in the InGaN layer. However, the light-emitting efficiency of a thin film-type InGaN LED becomes low as the wavelength of the thin film-type InGaN LED increases. In particular, the light-emitting efficiency of the thin film-type InGaN LED may be reduced in a green light wavelength bandwidth due to a lattice mismatch between the thin film-type InGaN LED and a substrate.

### SUMMARY

Example embodiments relate to white light-emitting diodes that include a plurality of nano light-emitting units that have a hexagonal-pyramid shape nanostructure and are configured to generate white light without using a phosphor.

Additional aspects will be set forth in part in the description which follows and, in part, will be apparent from the description, or may be learned by practice of example embodiments.

According to example embodiments, a white light-emitting diode includes a first semiconductor layer including a plurality of hexagonal-pyramid shape nanostructures that protrude upwards from an upper surface of the first semiconductor layer, at least two multi-quantum well layers that are sequentially stacked on the hexagonal-pyramid shape nanostructures, and a second semiconductor layer on the at least two multi-quantum well layers.

The white light-emitting diode may further include an insulating layer pattern that surrounds at least part of the plurality of hexagonal-pyramid shape nanostructures. The insulating layer pattern may define bottom surfaces of the plurality of hexagonal-pyramid shape nanostructures.

The multi-quantum well layers may respectively include a plurality of quantum wells and barriers that surround the quantum wells, and the barriers may be doped with a p-type dopant to a concentration in a range from about 1×10¹⁶ cm⁻³ to about 1×10¹⁹ cm⁻³_{.}

The quantum wells may be formed of InGaN, and the barriers may be formed of GaN or InGaN.

The white light-emitting diode may further include a tunnel junction layer between the at least two multi-quantum well layers.

The tunnel junction layer may include a p+ semiconductor layer doped with a p+ dopant and an n+ semiconductor layer doped with an n+ dopant, and the p+ semiconductor layer and the n+ semiconductor layer may have a doping concentration in a range from about 1×10¹⁷ cm⁻³ to about 5×10²⁰ cm⁻³, respectively.

The tunnel junction layer may include at least one of AlInGaN, InGaN, GaN, and AlGaN.

The at least two multi-quantum well layers may include a first multi-quantum well layer on the hexagonal-pyramid shape nanostructure and a second multi-quantum well layer on the first multi-quantum well layer. The first multi-quantum well layer may be configured to emit a first wavelength of light. The second multi-quantum well layer may be configured to emit a second wavelength of light. The first wavelength of light may be shorter than the second wavelength.

Each of the at least two multi-quantum well layers may include a semi-polar surface.

The at least two multi-quantum well layers may be configured to generate light that mixes to produce white light.

According to example embodiments, a white light-emitting diode includes at least one first multi-quantum well layer on a first semiconductor layer, a second semiconductor layer including a plurality of hexagonal-pyramid shape nanostructures that protrude upwards from an upper surface of the second semiconductor layer, at least one second multi-quantum well layer on the plurality of hexagonal-pyramid shape nanostructures, and a third semiconductor layer on the at least one second multi-quantum well layer.

An insulating pattern may surround bottom surfaces of the plurality of the hexagonal-pyramid shape nanostructures. The insulating pattern may define bottom surfaces of the plurality of the hexagonal-pyramid shape nanostructures.

Each of the at least one first multi-quantum well layer and the at least one second multi-quantum well layer may include a plurality of quantum wells and barriers. The barriers may surround the quantum wells. The barriers may be doped with a p-type dopant at a concentration in a range from about 1 x 10¹⁶ cm⁻³ to about 1 x 10¹⁹ cm⁻³.

The quantum wells may be formed of InGaN, and the barriers may be formed of GaN or InGaN.

The white light-emitting diode may further include a tunnel junction layer between the at least one first multi-quantum well layer and the at least one second multi-quantum well layer.

The tunnel junction layer may be on the plurality of hexagonal-pyramid shape nanostructures. The tunnel junction layer may be between the plurality of hexagonal-pyramid shape nanostructures and the at least one second multi-quantum well layer.

The tunnel junction layer may be formed under the plurality of hexagonal-pyramid shape nanostructures. The tunnel junction layer may be between the plurality of hexagonal-pyramid shape nanostructures and the at least one first multi-quantum well layer.

The tunnel junction layer may include a p+ semiconductor layer doped with a p+ dopant and an n+ semiconductor layer doped with an n+ dopant. The p+ semiconductor layer and the n+ semiconductor layer may have a doping concentration in a range from about 1 x 10¹⁷ cm⁻³ to about 1 x 10²⁰ cm⁻³.

The tunnel junction layer may include at least one of AlInGaN, InGAN, GaN, and AlGaN.

The first multi-quantum well layer may be configured to emit a first wavelength of light. The second multi-quantum well layer may be configured to emit a second wavelength of light. The first wavelength of light may be shorter than the second wavelength of light. The first multi-quantum well layer and second multi-quantum well layer may be configured to generate white light in combination, based on the first wavelength of light from the first multi-quantum well layer mixing with the second wavelength of light from the second multi-quantum well layer.

The at least one second multi-quantum well layer may include a semi-polar surface.

According to example embodiments, a white light-emitting diode may include a plurality of hexagonal-pyramid shape nanostructures protruding from one of a first semiconductor layer and a second semiconductor layer, the second semiconductor layer being on the first semiconductor layer, at least one first multi-quantum well layer configured to emit blue light and being between the first and second semiconductor layers, and at least one other multi-quantum well layer on the plurality of hexagonal-pyramid shape nanostructures. The at least one other multi-quantum well layer may be configured to emit non-blue light that mixes with the blue light from the at least one first multi-quantum well layer in order to generate white light.

The white-light emitting diode may further include a first electrode connected to the first semiconductor layer, a second electrode connected to the second semiconductor layer, and a transparent electrode connected to the second electrode, wherein the plurality of hexagonal-pyramid shape nanostructures are spaced apart and protrude from the first semiconductor layer, the at least one first multi-quantum well layer is on the plurality of hexagonal-pyramid shape nanostructures, the at least one other multi-quantum well layer includes at least one second multi-quantum well layer on the at least one first multi-quantum well layer, the at least one second multi-quantum well layer is configured to emit yellow light, and the transparent electrode is on the at least one second multi-quantum well layer.

The white-light emitting diode may further include a first electrode connected to the second semiconductor layer, a third semiconductor layer, a second electrode connected to the third semiconductor layer, and a transparent electrode connected to the second electrode. The plurality of hexagonal-pyramid shape nanostructures may protrude from the second semiconductor layer and be spaced apart. The at least one other multi-quantum well layer may include at least one second multi-quantum well layer between the plurality of hexagonal-pyramid shape nanostructures and the transparent electrode, and the at least one second multi-quantum well layer may be configured to emit yellow light.

In a white light-emitting diode according to example embodiments, light-emitting units that emit light having a long wavelength are formed in a hexagonal-pyramid shape nanostructure. Accordingly, there are no crystal defects (or substantial no crystal defects) due to lattice mismatch with a substrate, and thus, high internal quantum efficiency may be realized. Also, the light-emitting units having a hexagonal-pyramid shape nanostructure may be formed smaller than an emitted wavelength. Accordingly, optical extraction efficiency may reach almost 100%, thereby increasing external quantum efficiency.

Also, white light is generated by emitting different lights from stacked multi-quantum well layers. Accordingly, a simple structure of a white light-emitting diode may be manufactured.

### BRIEF DESCRIPTION OF THE DRAWINGS

The foregoing and/or other features and advantages of example embodiments will become apparent and more readily appreciated from the following description of non-limiting embodiments, taken in conjunction with the accompanying drawings in which like reference characters refer to the same parts throughout the different views. The drawings are not necessarily to scale, emphasis instead being placed upon illustrating the principles of example embodiments. In the drawings which:
FIG. 1 is a schematic cross-sectional view of a white light-emitting diode having a plurality of nano light-emitting units according to example embodiments;
FIG. 2 is a perspective view of a hexagonal-pyramid type nanostructure according to example embodiments;
FIG. 3 is a plan view of a nanostructure array according to example embodiments;
FIG. 4 is a magnified cross-sectional view of the portion A of the nano light-emitting unit of FIG. 1;
FIG. 5 is a schematic cross-sectional view of a white light-emitting diode having a plurality of nano light-emitting units according to example embodiments;
FIG. 6 is a schematic drawing of a band gap diagram of a multi-quantum well structure of FIG. 5;
FIG. 7 is a schematic cross-sectional view of a white light-emitting diode having a plurality of nano light-emitting units according to still example embodiments;
FIG. 8 is a schematic cross-sectional view of a white light-emitting diode having a plurality of nano light-emitting units according to still example embodiments; and
FIG. 9 is a schematic cross-sectional view of a white light-emitting diode having a plurality of nano light-emitting units according to still example embodiments.

### DETAILED DESCRIPTION

Example embodiments will now be described more fully with reference to the accompanying drawings, in which some example embodiments are shown. Example embodiments, may, however, be embodied in many different forms and should not be construed as being limited to the embodiments set forth herein; rather, these example embodiments are provided so that this disclosure will be thorough and complete, and will fully convey the scope of example embodiments of inventive concepts to those of ordinary skill in the art. In the drawings, the thicknesses of layers and regions are exaggerated for clarity. Like reference numerals in the drawings denote like elements, and thus their description may be omitted.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. As used herein the term "and/or" includes any and all combinations of one or more of the associated listed items. Other words used to describe the relationship between elements or layers should be interpreted in a like fashion (e.g., "between" versus "directly between," "adjacent" versus "directly adjacent," "on" versus "directly on").

It will be understood that, although the terms "first", "second", etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, a first element, component, region, layer or section discussed below could be termed a second element, component, region, layer or section without departing from the teachings of example embodiments.

Spatially relative terms, such as "beneath," "below," "lower," "above," "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

The terminology used herein is for the purpose of describing particular embodiments only and is not intended to be limiting of example embodiments. As used herein, the singular forms "a," "an" and "the" are intended to include the plural forms as well, unless the context clearly indicates otherwise. It will be further understood that the terms "comprises", "comprising", "includes" and/or "including," if used herein, specify the presence of stated features, integers, steps, operations, elements and/or components, but do not preclude the presence or addition of one or more other features, integers, steps, operations, elements, components and/or groups thereof. Expressions such as "at least one of," when preceding a list of elements, modify the entire list of elements and do not modify the individual elements of the list.

Example embodiments are described herein with reference to cross-sectional illustrations that are schematic illustrations of idealized embodiments (and intermediate structures) of example embodiments. As such, variations from the shapes of the illustrations as a result, for example, of manufacturing techniques and/or tolerances, are to be expected. Thus, example embodiments should not be construed as limited to the particular shapes of regions illustrated herein but are to include deviations in shapes that result, for example, from manufacturing. For example, an implanted region illustrated as a rectangle may have rounded or curved features and/or a gradient of implant concentration at its edges rather than a binary change from implanted to non-implanted region. Likewise, a buried region formed by implantation may result in some implantation in the region between the buried region and the surface through which the implantation takes place. Thus, the regions illustrated in the figures are schematic in nature and their shapes are not intended to illustrate the actual shape of a region of a device and are not intended to limit the scope of example embodiments.

Unless otherwise defined, all terms (including technical and scientific terms) used herein have the same meaning as commonly understood by one of ordinary skill in the art to which example embodiments belong. It will be further understood that terms, such as those defined in commonly-used dictionaries, should be interpreted as having a meaning that is consistent with their meaning in the context of the relevant art and will not be interpreted in an idealized or overly formal sense unless expressly so defined herein.

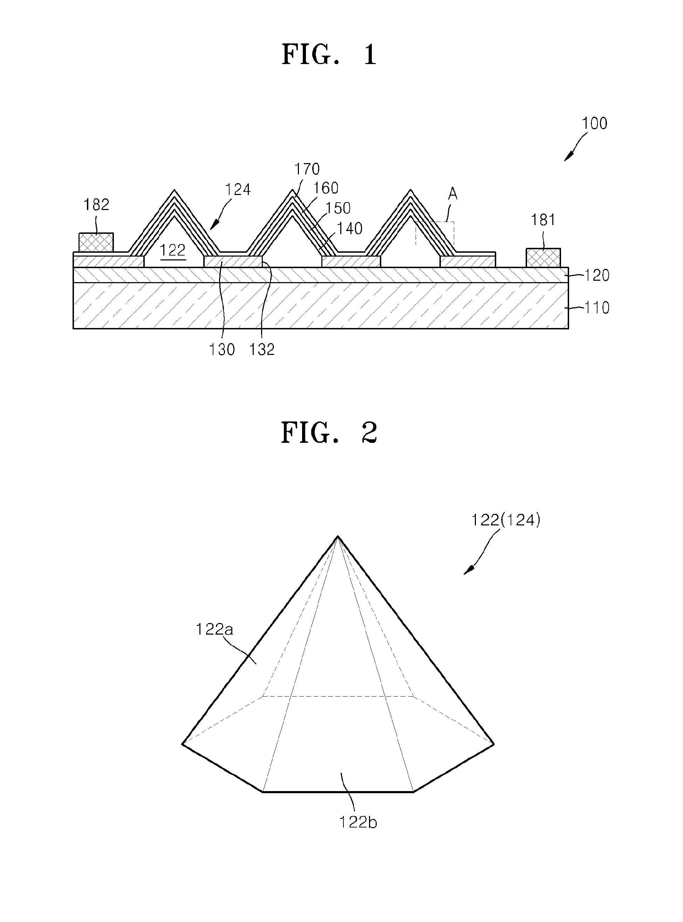

FIG. 1 is a schematic cross-sectional view of a white light-emitting diode 100 having a plurality of nano light-emitting units according to example embodiments

Referring to FIG. 1, a first semiconductor layer 120 is formed on a substrate 110. The substrate 110 may be formed of sapphire, SiC, or GaN. Alternatively, the substrate may be formed of Si, ZnO, GaAs, MgAl₂O₄, MgO, LiAlO₂, LiGaO₂ and GaN, but example embodiments are not limited thereto. Although not shown, a buffer layer for epitaxial growth may be formed on the substrate 110.

An insulating layer pattern 130 is formed on an upper surface of the first semiconductor layer 120. The insulating layer pattern 130 may include holes 132 having a hexagonal shape. The insulating layer may include a dielectric material such as silicon oxide, but example embodiments are not limited thereto.

A plurality of hexagonal-pyramid shape nanostructures 122 protrude from the holes 132 formed on the insulating layer pattern 130. The hexagonal-pyramid shape nanostructures 122 form a nanostructure array. The nanostructure array of the hexagonal-pyramid shape nanostructures 122 is epitaxially grown from the first semiconductor layer 120 that is exposed in the holes 132 of the insulating layer pattern 130.

The first semiconductor layer 120 including the nanostructure array of the hexagonal-pyramid shape nanostructures 122 may be a semiconductor layer doped with a first type dopant, that is, an n-type dopant. The first semiconductor layer 120 and the nanostructure 122 array may be formed of a group III-V nitride semiconductor material, for example, n-GaN. The n-type dopant may be Si. However, example embodiments are not limited thereto. For example, Ge, Se, and Te may alternatively be used as n-type dopants.

At least two multi-quantum wells are sequentially stacked on each of the hexagonal-pyramid shape nanostructures 122. In the white light-emitting diode 100 of FIG. 1, a first multi-quantum well layer 140 and a second multi-quantum well layer 150 are stacked on each of the hexagonal-pyramid shape nanostructures 122. A second semiconductor layer 160 is formed on the second multi-quantum well layer 150. The hexagonal-pyramid shape nanostructures 122 and the first multi-quantum well layer 140, the second multi-quantum well layer 150, and the second semiconductor layer 160 on the hexagonal-pyramid shape nanostructures 122 constitute a nano light-emitting unit 124. According to example embodiments, the white light-emitting diode 100 may include a nano light-emitting unit array.

The second semiconductor layer 160 may be a semiconductor layer doped with, for example, a p-type dopant. The second semiconductor layer 160 may be formed of a group III-V nitride semiconductor material, for example, p-GaN. The p-type dopant may be Mg, Ca, Zn, Cd, or Hg.

A transparent electrode layer 170 that coves the nano light-emitting unit array is formed on the insulating layer pattern 130. The white light-emitting diode 100 may have a mesa structure in which a region of the first semiconductor layer 120 is exposed, and a first electrode 181 may be formed on the exposed region of the first semiconductor layer 120. A second electrode 182 is formed on a side of an upper surface of the transparent electrode layer 170. The transparent electrode layer 170 may include at least one transparent conductive oxide, such as zinc oxide (ZnO), indium oxide (InO), indium tin oxide (ITO), and tin oxide (SnO), but example embodiments are not limited thereto.

The arrangement of the first and second electrodes 181 and 182 according to example embodiments is not limited to that of FIG. 1. For example, the first electrode 181 may be connected to a lower surface of the first semiconductor layer 120 after removing a portion of the substrate 110.

Also, as an example, according to example embodiments, light is emitted in a direction of the transparent electrode layer 170. However, example embodiments are not limited thereto. For example, light may be emitted in a direction of the substrate 110. In this case, the transparent electrode layer 170 may be formed of a material that has an ohmic characteristic and reflects light.

The first multi-quantum well layer 140 and the second multi-quantum well layer 150 generate light by recombination of electrons and holes, and may be formed of a nitride semiconductor based on InGaN. Light emitting wavelength bandwidths of the first and second multi-quantum well layers 140 and 150 may be controlled by controlling band gap energies of the first and second multi-quantum well layers 140 and 150. For example, a quantum well layer and a barrier of each of the first and second multi-quantum well layers 140 and 150 may be formed of a pair of InGaN/GaN, InGaN/InGaN, InGaN/AlGaN, or InGaN/InAlGaN.

The second multi-quantum well layer 150 may have a band gap that is smaller than a band gap of the first multi-quantum well layer 140. In the white light-emitting diode 100 according to example embodiments, white light is generated by mixing light that has a first wavelength and is emitted from the first multi-quantum well layer 140 and light that has a second wavelength and is emitted from the second multi-quantum well layer 150.

According to example embodiments, the first multi-quantum well layer 140 may be configured to generate blue light, and the mole fraction of indium in the InGaN layer may be determined to emit blue light. In general, when the mole fraction of indium changes 1%, the light emitting wavelength is shifted by approximately 5 nm. In order to generate blue light, the mole fraction of indium in the InGaN layer is, for example, approximately 20%.

The second multi-quantum well layer 150 may be configured to emit yellow light. In order to emit yellow light, the mole fraction of indium in the InGaN layer may be approximately 50%.

In manufacturing the first semiconductor layer 120, the first multi-quantum well layer 140, second multi-quantum well layer 150, and the second semiconductor layer 160, various methods may be used generally known as a method of growing a group III-V compound semiconductor, for example, a metal organic chemical vapor deposition (MOCVD) method, a hydride vapor phase epitaxy (HVPE) method, a molecular beam epitaxy (MBE) method, a metal organic vapor phase epitaxy (MOVPE) method, or a halide chemical vapor deposition (HCVD) method.

FIG. 2 is a perspective view of the nanostructures 122 having a hexagonal-pyramid shape of FIG. 1.

Referring to FIG. 2, the hexagonal-pyramid shape nanostructures 122 may have substantially the same shape as the nano light-emitting units 124. Each of the hexagonal-pyramid shape nanostructures 122 may include six side surfaces 122a and a bottom surface 122b. The side surfaces 122a may be semi-polar surfaces. The bottom surface 122b may have a size in a range from about 10 nm to about 1,000 nm and may be a non-polar surface.

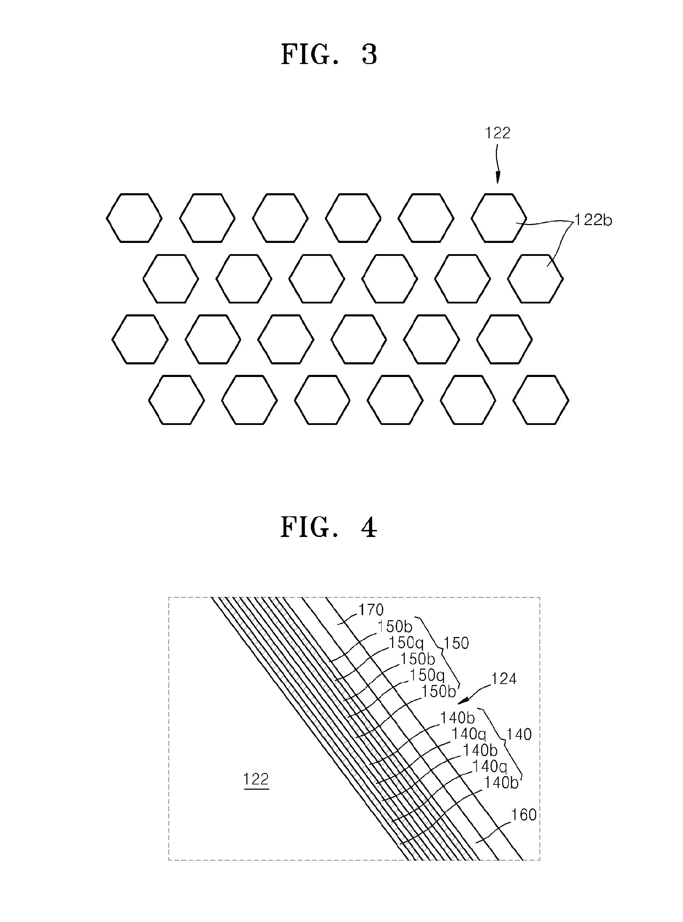

FIG. 3 is a plan view of an array of hexagonal-pyramid shape nanostructures 122 according to example embodiments. The bottom surfaces 122b of the hexagonal-pyramid shape nanostructures 122 may be arranged at desired (and/or alternatively predetermined) gaps. The hexagonal-pyramid shape nanostructures 122 may be disposed in a zigzag shape. In this case, the bottom surfaces 122b may be arranged in a honey comb shape. However, the arrangement of the bottom surfaces 122b according to example embodiments is not limited thereto, and the bottom surfaces 122b may be arranged in a matrix type.

In the nano light-emitting units 124, for example, the content of In in an InGaN multi-quantum well layer may be freely increased, and also, internal quantum efficiency may increase by reducing crystal defects caused by lattice mismatch. Also, when the size of the nano light-emitting units 124 is small compared to a wavelength of light, extraction efficiency of light is increased, and thus, the external quantum efficiency may also be increased. Also, the nano light-emitting units 124 may absorb the deformation due to a stress of a multi-quantum well layer, and thus, may reduce piezoelectric polarization caused by the stress of the multi-quantum well layer. The nano light-emitting units 124 may increase an optical efficiency of light having a long wavelength, for example, more than 500 nm, by reducing the generation of the piezoelectric polarization and may increase efficiency at a high current operation.

Also, the nano light-emitting units 124 may obtain a high optical output because a surface area of each of the multi-quantum well layers is wide. The first and second electrodes 181 and 182 are connected to an external power supply unit so that electrons and holes are injected into the nano light-emitting units 124, and may be formed of a metal such as Au, Al, or Ag or a transparent conductive material such as indium tin oxide (ITO).

FIG. 4 is a cross-sectional view of a portion A of the nano light-emitting unit 124 of FIG. 1.

Referring to FIG. 4, the nano light-emitting unit 124 includes the first multi-quantum well layer 140 and the second first multi-quantum well layer 150. The first multi-quantum well layer 140 may include three barriers 140b and two quantum wells 140q which are alternately disposed and epitaxially grown in a surface direction in the hexagonal-pyramid shape nanostructures 122. One quantum well 140q is interposed between two adjacently disposed two barriers 140b. Also, the second multi-quantum well layer 150 may include three barriers 150b and two quantum wells 150q which are alternately disposed and epitaxially grown in the surface direction on the first multi-quantum well layer 140. One quantum well 150q is interposed between two adjacently disposed two barriers 150b. In FIG. 4, for convenience of explanation, the first and second multi-quantum well layers 140 and 150 respectively have two quantum wells, but example embodiments are not limited thereto. For example, the first multi-quantum well layer 140 and the second multi-quantum well layer 150 respectively may have more than three quantum wells and barriers corresponding to the quantum wells.

As the numbers of the quantum wells 140q and 150q increase, holes are mainly distributed in the quantum well near a p-type semiconductor layer, for example, the second semiconductor layer 160, and holes may not reach to a quantum well near an n-type semiconductor layer, for example, the first semiconductor layer 120. This phenomenon occurs because the mobility of holes is remarkably lower than that of electrons. In this case, since light is emitted mainly near the p-type semiconductor layer, light emission efficiency may be reduced. Accordingly, in order to more uniformly supply holes to all quantum wells 140q and 150q, the barriers 140b and 150b may be doped with a p-type dopant. Then, the barriers 140b and 150b doped with a p-type dopant may supply holes to the quantum wells 140q and 150q adjacent to the barriers 140b and 150b. At this point, all of the barriers 140b and 150b may be doped with a p-type dopant or a portion of the barriers 140b and 150b may be doped. The doping concentration of the barriers 140b and 150b may be slightly lower than an ordinary semiconductor doping concentration, for example, in a range from about 1×10¹⁶ cm⁻³ to about 1×10¹⁹ cm⁻³.

According to example embodiments, a nano light-emitting unit includes a first multi-quantum well layer and a second multi-quantum well layer, but example embodiments are not limited thereto. For example, the nano light-emitting unit may further include at least one multi-quantum well layer on the second multi-quantum well layer. In this case, the first multi-quantum well layer emits blue light and the second multi-quantum well layer emits green light, and the at least one multi-quantum well layer emits red light, and thus the light-emitting diode may generate white light.

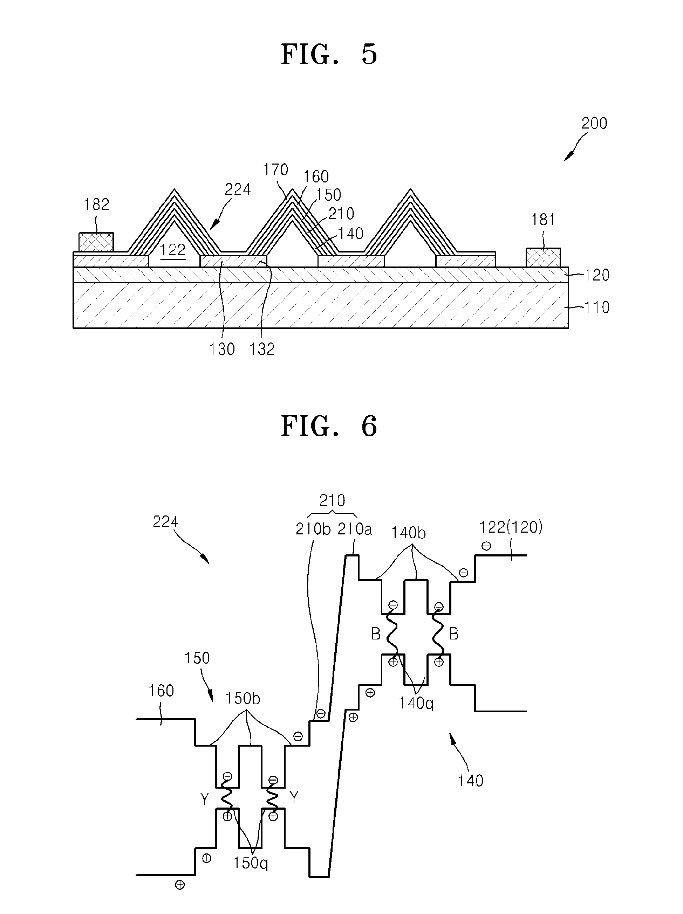

FIG. 5 is a schematic cross-sectional view of a white light-emitting diode 200 having a plurality of nano light-emitting units according to example embodiments. Like reference numerals are used to indicate elements that are the same (and/or substantially identical) to the elements of FIG. 1, and thus the detailed description thereof will not be repeated.

Referring to FIG. 5, in a method of supplying holes to a separated first multi-quantum well layer 140 from a second semiconductor layer 160 in a nano light-emitting unit 224, a tunnel junction layer is formed between the multi-quantum well layers. That is, a tunnel junction layer 210 is formed between the first multi-quantum well layer 140 and the second multi-quantum well layer 150.

FIG. 6 is a schematic drawing of a band gap diagram of the multi-quantum well structure of FIG. 5.

Referring to FIG. 6, the tunnel junction layer 210 having a p+ semiconductor layer 210a doped with p+ dopant and an n+ semiconductor layer 210b doped with n+ dopant is disposed between the first multi-quantum well layer 140 and the second multi-quantum well layer 150. The tunnel junction layer 210 is disposed between two barriers 140b and 150b. The p+ semiconductor layer 210a is disposed on a side of the first multi-quantum well layer 140 and the n+ semiconductor layer 210b is disposed on a side of the second multi-quantum well layer 150. Accordingly, the nano light-emitting unit 224 in which the tunnel junction layer 210 is further disposed has a p-i-n+-p+i-n structure. In FIG. 6, only one tunnel junction layer 210 is depicted. However, a plurality of tunnel junction layers 210 may be formed in the nano light-emitting unit 224.

When a biased voltage is applied to the tunnel junction layer 210, pairs of electron and hole are generated in the tunnel junction layer 210, and are supplied to first and second quantum wells 140q and 150q. That is, the p+ semiconductor layer 210a may supply holes to an adjacent quantum well 140q and the n+ semiconductor layer 210b may supply electrons to an adjacent quantum well 150q. For this purpose, the doping concentration of the p+ semiconductor layer 210a and the n+ semiconductor layer 210b may be, for example, in a range from about 1×10¹⁷ cm⁻³ to about 5×10²⁰ cm⁻³ which is slightly higher than that of an ordinary concentration of the semiconductor. The tunnel junction layer 210 may be formed of a material selected from the group consisting of AlInGaN, InGaN, GaN, and AlGaN.

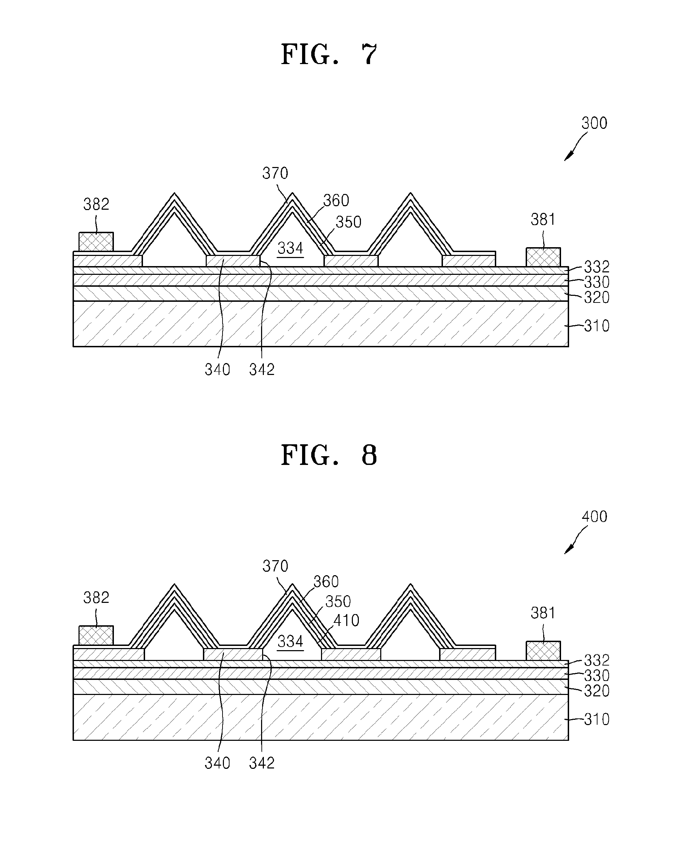

FIG. 7 is a schematic cross-sectional view of a white light-emitting diode 300 having a plurality of nano light-emitting units according to example embodiments. Like reference numerals are used to indicate elements that are the same as (and/or substantially identical to) the elements of FIG. 1, and thus the detailed description thereof will not be repeated.

Referring to FIG. 7, a first semiconductor layer 320 is formed on a substrate 310. The substrate 310 may be formed of sapphire, silicon carbide SiC, or GaN. Alternatively, the substrate 310 may be formed of Si, ZnO, GaAs, MgAl₂O₄, MgO, LiAlO₂, LiGaO₂ and GaN, but example embodiments are not limited thereto. Although not shown, a buffer layer for epitaxial growth may further be formed on the substrate 310.

The first semiconductor layer 320 may be a semiconductor layer doped with a first dopant, for example, an n-type dopant. The first semiconductor layer 320 may be formed of a group III-V nitride semiconductor material, for example, n-GaN. The n-type dopant may be Si. However, example embodiments are not limited thereto. For example, Ge, Se, and Te may alternatively be used as n-type dopants.

A first multi-quantum well layer 330 is formed on an upper surface of the first semiconductor layer 320. The first multi-quantum well layer 330 emits light by recombination of electron and holes, and may be formed of a nitride semiconductor layer based on, for example, InGaN. A light-emitting wavelength bandwidth of the first multi-quantum well layer 330 is controlled by controlling a band gap energy of the first multi-quantum well layer 330. The first multi-quantum well layer 330 may have a structure in which quantum well layers and barriers are alternately disposed, and may be formed of a pair of InGaN/GaN, InGaN/InGaN, InGaN/AlGaN, or InGaN/InAlGaN.

A second semiconductor layer 332 is formed on the first multi-quantum well layer 330. The second semiconductor layer 332 may be a semiconductor layer doped with a first type dopant, for example, an n-type dopant. The second semiconductor layer 332 may be formed of a group III-V nitride semiconductor material, for example, n-GaN. The n-type dopant may be Si. However, example embodiments are not limited thereto. For example, Ge, Se, and Te may alternatively be used as n-type dopants.

An insulating layer pattern 340 is formed on an upper surface of the second semiconductor layer 332. The insulating layer pattern 340 may be a pattern in which hexagonal shape holes 342 are formed. The insulating layer pattern 340 may be formed of a dielectric material, such as silicon oxide, but example embodiments are not limited thereto.

Hexagonal-pyramid shape nanostructures 334 protrude from the holes 342 of the insulating layer pattern 340. The hexagonal-pyramid shape nanostructures 334 constitute a nanostructure array. The nanostructure array of the hexagonal-pyramid shape nanostructures 334 is epitaxially grown from the second semiconductor layer 332 exposed in the holes 342 of the insulating layer pattern 340.

At least one multi-quantum well is stacked on each of the hexagonal-pyramid shape nanostructures 334. In the white light-emitting diode 300 of FIG. 7, a second multi-quantum well layer 350 is stacked on the hexagonal-pyramid shape nanostructures 334. A third semiconductor layer 360 is formed on the second multi-quantum well layer 350.

The third semiconductor layer 360 may be a semiconductor layer doped with a second dopant, for example, a p-type dopant. The third semiconductor layer 360 may be formed of a group III-V nitride semiconductor material, for example, p-GaN. The p-type dopant may be Mg, Ca, Zn, Cd, or Hg, but example embodiments are not limited thereto.

A transparent electrode layer 370 that covers the nanostructure array is formed on the insulating layer pattern 340 and third semiconductor layer 360. The white light-emitting diode 300 may have a mesa structure in which a region of the second semiconductor layer 332 is exposed. A first electrode 381 is formed on the exposed region of the second semiconductor layer 332. A second electrode 382 is formed on a side of an upper surface of the transparent electrode layer 370. The transparent electrode layer 170 may include at least one transparent conductive oxide, such as zinc oxide (ZnO), indium oxide (InO), indium tin oxide (ITO), and tin oxide (SnO), but example embodiments are not limited thereto.

According to example embodiments, light may be emitted in a direction of the transparent electrode layer 370, but example embodiments are not limited thereto. For example, light may be emitted in a direction of the substrate 310, and in this case, the transparent electrode layer 370 may have an ohmic characteristic and may be formed of a material that reflects light.

The first multi-quantum well layer 330 and the second multi-quantum well layer 350 emit light by recombination of electrons and holes, and may be formed of a nitride semiconductor layer based on, for example, InGaN. A light-emitting wavelength bandwidth of the first multi-quantum well layer 330 is controlled by controlling band gap energy of the first multi-quantum well layer 330. In each of the first and second multi-quantum well layers 330 and 350, quantum well layers and barriers may be formed of a pair of InGaN/GaN, InGaN/InGaN, InGaN/AlGaN, or InGaN/InAlGaN.

The second multi-quantum well layer 350 may have a band gap smaller than that of the first multi-quantum well layer 330. In the white light-emitting diode 300, white light is generated by mixing light having a first wavelength emitted from the first multi-quantum well layer 330 and light having a second wavelength emitted from the second multi-quantum well layer 350.

According to example embodiments, the first multi-quantum well layer 330 may be configured to emit blue light, and the mole fraction of In in the InGaN layer is determined to emit blue light. In general, when the mole fraction of In changes by 1%, the light emitting wavelength is shifted by approximately 5 nm. In order to generate blue light, the mole fraction of In in the InGaN layer is, for example, approximately 20%.

The second multi-quantum well layer 350 may be configured to emit yellow light. In order to emit yellow light, the mole fraction of In in the InGaN layer may be approximately 50%.

In manufacturing the first semiconductor layer 320, the first multi-quantum well layer 330, second multi-quantum well layer 350, and the second semiconductor layer 360, various methods may be used generally known as a method of growing a group III-V compound semiconductor, for example, a MOCVD method, a HVPE method, a MBE method, a MOVPE method, or a HCVD method.

The shapes of the hexagonal-pyramid shape nanostructures 322 and the second multi-quantum well layer 350 on the hexagonal-pyramid shape nanostructures 322 are substantially the same as that of the hexagonal-pyramid shape nanostructures 122 of FIGS. 2 and 3, and thus, the description thereof will not be repeated. Also, the structure of the second multi-quantum well layer 350 may be known from the hexagonal-pyramid shape nanostructures 122 of FIG. 4, and thus, the description thereof will not be repeated.

FIG. 8 is a schematic cross-sectional view of a white light-emitting diode 400 having a plurality of nano light-emitting units according to example embodiments. Like reference numerals are used to indicate elements that are the same (and/or substantially identical) to the elements of FIG. 7, and thus, the detailed description thereof will not be repeated.

Referring to FIG. 8, in a method of supplying holes to a quantum well of the first multi-quantum well layer 330 that is separated from the third semiconductor layer 360, a tunnel junction layer 410 is formed between the first multi-quantum well layer 330 and the second multi-quantum well layer 350.

The tunnel junction layer 410 is formed on the hexagonal-pyramid shape nanostructure 334.

The tunnel junction layer 410 includes a p+ semiconductor layer (not shown) doped with a p+ dopant and an n+ semiconductor layer (not shown) doped with an n+ dopant. The p+ semiconductor layer is disposed on a side of the first multi-quantum well layer 330, and the n+ semiconductor layer is disposed on a side of the second multi-quantum well layer 350.

The second multi-quantum well layer 350 is formed on the tunnel junction layer 410. The structure of the second multi-quantum well layer 350 is the same (and/or substantially the same) as that of the second multi-quantum well layer 350 of FIG. 7, and thus, the detailed description thereof will not be repeated.

The tunnel junction layer 410 may be understood from the structure of the tunnel junction layer 210 of FIGS. 5 and 6, and thus, the detailed description thereof will not be repeated.

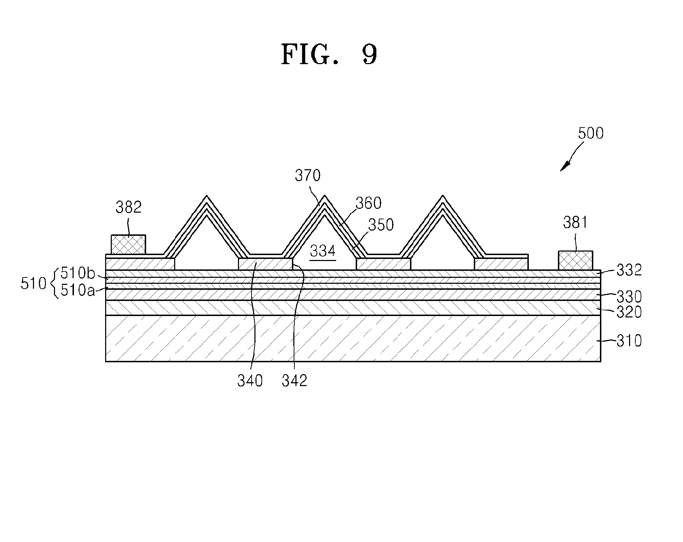

FIG. 9 is a schematic cross-sectional view of a white light-emitting diode 500 having a plurality of nano light-emitting units according to example embodiments. Like reference numerals are used to indicate elements that are substantially identical to the elements of FIG. 7, and thus, the detailed description thereof will not be repeated.

Referring to FIG. 9, as a method of supplying holes to a quantum well of the first multi-quantum well layer 330 that is separated from the third semiconductor layer 360, a tunnel junction layer 510 is formed between the first multi-quantum well layer 330 and the second multi-quantum well layer 350.

The tunnel junction layer 510 includes a p+ semiconductor layer 510a doped with a p+ dopant and an n+ semiconductor layer 510b doped with an n+ dopant. The p+ semiconductor layer 510a is disposed on a side of the first multi-quantum well layer 330, and the n+ semiconductor layer 510b is disposed on a side of the second multi-quantum well layer 350. A second semiconductor layer 332 is formed on the tunnel junction layer 510. The structure of the second semiconductor layer 332 is substantially the same as that of the second semiconductor layer 332 of FIG. 7, and thus, the detailed description thereof will not be repeated.

When a biased voltage is applied to the tunnel junction layer 510, pairs of electrons and holes are generated in the tunnel junction layer 510. Thus, the p+ semiconductor layer 510a may supply holes to an adjacent quantum well and the n+ semiconductor layer 510b may supply electrons to an adjacent quantum well. For this purpose, the doping concentration of the p+ semiconductor layer 510a and the n+ semiconductor layer 510b may be, for example, in a range from about 1×10¹⁷ cm⁻³ to about 5×10²⁰ cm⁻³ which is slightly higher than that of an ordinary semiconductor. The tunnel junction layer 510 may be formed of a material selected from the group consisting of AlInGaN, InGaN, GaN, and AlGaN.

## Claims

1. A white light-emitting diode comprising:
a first semiconductor layer including a plurality of hexagonal-pyramid shape nanostructures that protrude upwards from an upper surface of the first semiconductor layer;
at least two multi-quantum well layers, at least one of the multi-quantum well layers being on the plurality of the hexagonal-pyramid shape nanostructures and at least one of the multi-quantum well layers or under the first emiconductor layer; and
a second semiconductor layer on the at least two multi-quantum well layers.

2. The white light-emitting diode of claim 1, wherein each of the at least two multi-quantum well layers are all on the plurality of the hexagonal-pyramid shape nanostructures

3. The white light-emitting diode of claim 1 or 2, further comprising:
an insulating pattern that surrounds at least part of the plurality of the hexagonal-pyramid shape nanostructures, wherein the insulating pattern defines bottom surfaces of the plurality of the hexagonal-pyramid shape nanostructures.

4. The white light-emitting diode of claim 1, 2 or 3, wherein:
the at least two multi-quantum well layers respectively comprise a plurality of quantum wells and barriers,
the barriers surround the quantum wells, and
the barriers are doped with a p-type dopant to a concentration in a range from 1×10¹⁶ cm⁻³ to 1×10¹⁹ cm⁻³.

5. The white light-emitting diode of any preceding claim, wherein
the plurality of the quantum wells contain InGaN, and
the barriers contain at least one of GaN and InGaN.

6. The white light-emitting diode of any preceding claim, further comprising:
a tunnel junction layer between the at least two multi-quantum well layers.

7. The white light-emitting diode of claim 6, wherein
the tunnel junction layer includes a p+ semiconductor layer doped with a p+ dopant and an n+ semiconductor layer doped with an n+ dopant, and
the p+ semiconductor layer and the n+ semiconductor layer have a doping concentration in a range from 1×10¹⁷ cm⁻³ to 5×10²⁰ cm⁻³, respectively,
and further preferably wherein the tunnel junction layer includes one of AlInGaN, InGaN, GaN, and AlGaN.

8. The white light-emitting diode of any preceding claim, wherein
the at least two multi-quantum well layers include a first multi-quantum well layer on the hexagonal-pyramid shape nanostructure and a second multi-quantum well layer on the first multi-quantum well layer,
the first multi-quantum well layer is configured to emit a first wavelength of light,
the second multi-quantum well layer is configured to emit a second wavelength of light, and
the first wavelength of light is shorter than the second wavelength of light emitted.

9. The white light-emitting diode of claim 8, further comprising:
a tunnel junction layer between the first multi-quantum well layer and the second multi-quantum well layer.

10. The white light-emitting diode of any preceding claim, wherein each of the at least two multi-quantum well layers includes a semi-polar surface.

11. The white light-emitting diode of any preceding claim, wherein the at least two multi-quantum well layers are configured to generate light that mixes to produce white light.

12. A white light-emitting diode according to any preceding claim, wherein
at least one of the multi-quantum well layers is under the first semiconductor layer, and
further comprising a third semiconductor layer on the at least one second multi-quantum well layer.

13. The white light-emitting diode of claim 12, further comprising:
an insulating pattern that surrounds bottom surfaces of the plurality of the hexagonal-pyramid shape nanostructures, wherein the insulating pattern defines bottom surfaces of the plurality of the hexagonal-pyramid shape nanostructures.

14. The white light-emitting diode of claim 12 when dependent on claim 6, wherein:
the tunnel junction layer is between the plurality of hexagonal-pyramid shape nanostructures and the at least one multi-quantum well layer under the first semiconductor layer.

15. The white light-emitting diode of claim 12, 13, or 14, wherein the at least one multi-quantum well layer on the plurality of the hexagonal-pyramid shape nanostructures includes a semi-polar surface.
